Europäisches Patentamt

**European Patent Office**

Office européen des brevets

(11) Publication number: **0 324 606**
**A1**

## (12) EUROPEAN PATENT APPLICATION

(21) Application number: **89300237.8**

(22) Date of filing: **12.01.89**

(51) Int. Cl.⁴: **G 01 D 5/26**
**G 08 B 13/18, G 08 G 1/04**

(30) Priority: **12.01.88 AR 309827**

(43) Date of publication of application:
**19.07.89 Bulletin 89/29**

(84) Designated Contracting States: **DE FR GB IT NL**

(71) Applicant: **Hawryluk, Jose Carlos**
**Catamarca 2550**
**1636 Olivos Buenos Aires (AR)**

(72) Inventor: **Hawryluk, Jose Carlos**
**Catamarca 2550**
**1636 Olivos Buenos Aires (AR)**

(74) Representative: **Valentine, Francis Anthony Brinsley et al**
**REDDIE & GROSE 16 Theobalds Road**
**London WC1X 8PL (GB)**

(54) Multifunctional optoelectronic control apparatus.

(57) The invention refers to optoelectronic reflection-operated switches, and may find general application in domestic and industrial electrical circuits and particularly is suited for controlling brightness or timing of household lights and equipment. An optical transceiver assembly (20) transmits radiation and is activated when said radiation is reflected by a human member or other external object to generate a response. The reflected radiation is analysed by a circuit (157, 167, 169) to detect a predetermined parameter of the activating member or object such as position, distance, speed, dwelling-time, number of consecutive repetitive strikes, or a combination thereof. The analysed parameter is used by an output circuit (159) to determine a response parameter such as output signal intensity, time or selection according to a predetermined function. The invention further includes a remote-control arrangement (20, 300) virtually free from extraneous reflections in the vecinity of the assembly.

Fig. 3

Bundesdruckerei Berlin

**Description**

## MULTIFUNCTIONAL OPTOELECTRONIC CONTROL APPARATUS

The present invention generally relates to optoelectronic switches and in particular refers to an electronic apparatus for controlling one or more functions according to one or more activation parameters. The apparatus of the present invention preferably refers to an optical switch of the reflective type wherein activation is caused when a light-beam generated by an associated emitter is reflected when blocked by a person's finger or hand or by another reflective object, such that said light is incident on an optical receiver. Examples of this type of switch may be seen in the U.S. patent n° 3,086,146 and in the Argentine patent n° 231,202. The principle of operation forming the basis for this type of switch and how the latter is used for electrically switching a load, such as a lamp or a motor for example, may be clearly understood from these patents. In particular, the subject-matter of the former patent is to replace the well-known household electric-light switch, whilst that of the latter patent may be used for entering codes enabling protected elements or other objects requiring sequential identification.

The state of the art refers to switches having a single optical emitter/receiver pair, limited to simply detecting and checking light-reflection for generating a single control signal. For this reason, they are mainly used for handling a simple "T" or on/off toggle function on a pair of terminals in a power circuit or supply line. When it is desired to control various electrical loads, it is necessary to use a plurality of optoelectronic switches, one for each load.

By contrast, it is an object of the present invention to use a same single elemental electronic assembly for carrying out functions more complex than simply switching an output or controlling a plurality of outputs.

The present invention comprises an optical device in combination with an electronic circuit which not only carries out the aforementioned detection but furthermore analyses the reflected light-beam to select a corresponding control signal or output. That is, the apparatus of the present invention analyses a predetermined input parameter of the reflected signal to determine a response or effect on the load or loads connected thereto.

According to different embodiments of this invention, the analysed variable or parameter may be the blocking (activation) or dwell-time, the number of successive activations or "strikes", the distance, the position, etc., of the hand relative to the optical transceiver pair. According to the value resulting from the analysis of the chosen variable, the output response or effect may be either a direct function of the input variable or else determined by comparing the latter against a range of intervals or windows. In particular, the apparatus response may be a continuous variation of an output parameter, e.g. load intensity or power (quantitative selection), load timing (temporal selection), selecting between various loads connected thereto (spatial distribution), switching a load between two complementary states or imposing a definite state on a load (binary selection).

According to a first aspect of the present invention, the apparatus relates to an optoelectronic switch comprising a single optical emitter/receiver pair (or transceiver) by means of which a plurality of different responses or outputs (either output parameter values or a selection of physically distributed output lines) may be controlled. In a first embodiment, the analysed variable is the dwell-time, that is the time during which the hand is held blocking (i.e. a state of active reflection or activation) the optical pair. The dwelltime may be analysed with the aid of a pulse generator and an electronic counter control by means of an enabling signal provided by the illuminated receiver.

According to another possible embodiment of the invention, the activation variable is the distance between the hand and the emitter/receiver assembly. The distance is analysed by the apparatus of the present invention by determining the proportion of light reflected towards the receiver and comparing said quantity against a predetermined range calibrated in the circuit. In another embodiment of the present invention, the activation variable is the linear velocity of the hand in relation to the optical assembly. A value is generated on the basis of the speed with which the hand approaches or moves away from the optical switch to determine the effect on the output. To this end, the circuit comprises means for determining the variation of the intensity of the reflected signal, as detected by the optical receiver, wherein the signal is conveniently amplified and passed through a differentiation circuit or else through a couple of thresholds comparators associated with a time-base to determine the slope of the input signal.

According to yet another embodiment of the present invention, the activation variable is the quantity of successive activations or "strikes" within a certain time interval. These activations may be used to enter a time-interval or determine the intensity of an output variable.

According to a second aspect of the present invention, it is a further object to produce an optoelectronic switch operating on the basis of more than just a simple optical emitter/receiver pair, in order to obtain a better control over one or more outputs.

The apparatuses based on just a first emitter/receiver are also prone to other kinds of limitations such as, for example, the fact that they are generally of the toggling type wherein it may happen that the state of a controlled load is unknown, such that there is a risk that a mechanism may be mis-activated and produce an undesired result. For example, a motor may be assumed to be running and the switch is toggled with the intent of turning it off, when in actual fact the motor was not running and thus accidentally started and left running without the operator knowing it.

Another problem which may be associated in some cases with the use of a single optical pair is that the same may lead to confusion without being switched if it carries out a function other than simply switching between two states. In particular, if a person wanting to activate a switch is not familiar with its operation, he or she could misoperate it and endanger lives or cause damage to equipment. For example, if the optoelectronic switch controls a swimming-pool pump and a child gets dangerously close, it would be desireable in such an emergency for anybody to be able to quickly turn the motor off without having to previously read the instructions on how to do it. In other circumstances, it could be necessary to avoid undue activations, as could happen if somebody accidentally leans against the switch area, so that instead of turning it on the equipment connected thereto is turned off instantly if in operation. Another object of the invention is therefore to avoid accidental activations.

Consequently, according to the second aspect of the invention, the front panel on which the optical assembly is installed is provided with at least one additional emitter/receiver assembly, to enable the relative position of the hand on the panel to be detected. This variable, position, determines the resulting effect for controlling the output. The resulting effect may be turning on or off, increasing or reducing a linear or discrete variable, etc., according to the zone in which the finger was placed. To this end and according to a first embodiment, the optical assembly essentially comprises two optical assemblies. These assemblies could eventually comprise just three emitter or receiver elements in one of two different configurations, i.e.: one emitter and two receivers, each of the latter responsive to light reflected from a different one of said zones; or two emitters and one receiver, wherein each emitter is driven with a distinguishing modulation, either by phase or code.

Within the different embodiments which may be had, it is worth mentioning the one given preferential access to one of the optical devices over the other, or the one of simplifying its activation code, in order to favour one of the possible responses and achieve safer operation, particularly in emergency situations. As is apparent from the foregoing aspects, the activation variables mentioned above are used according to a predetermined function (linear or other) to determine an effect on the output. This effect may be a progressive lighting or dimming of the light in a room, timing of a hall light, starting and stopping of a pump, an emergency power-cut or a selection from a plurality of physically distributed loads as may be different household lights and devices. A further option open to the present invention is that of selecting, via the input-variable, from a plurality of lines to be individually activated, wherein furthermore a value or useful interval of said variable may be set apart for implementing a collective action, such as a master reset, for example.

Furthermore, the different aspects of the present invention may be used to meet other needs, as may be for controlling "tri-intensity" light-bulbs now found on the market having a double-filament arrangement for producing three fixed intensities "low/medium/high" and "off".

According to yet another aspect, the invention includes a remote-control arrangement for activating an electronic switch by reflection, the arrangement providing a relatively broad operational area without unduly increasing sensitivity to extraneous reflections in that area.

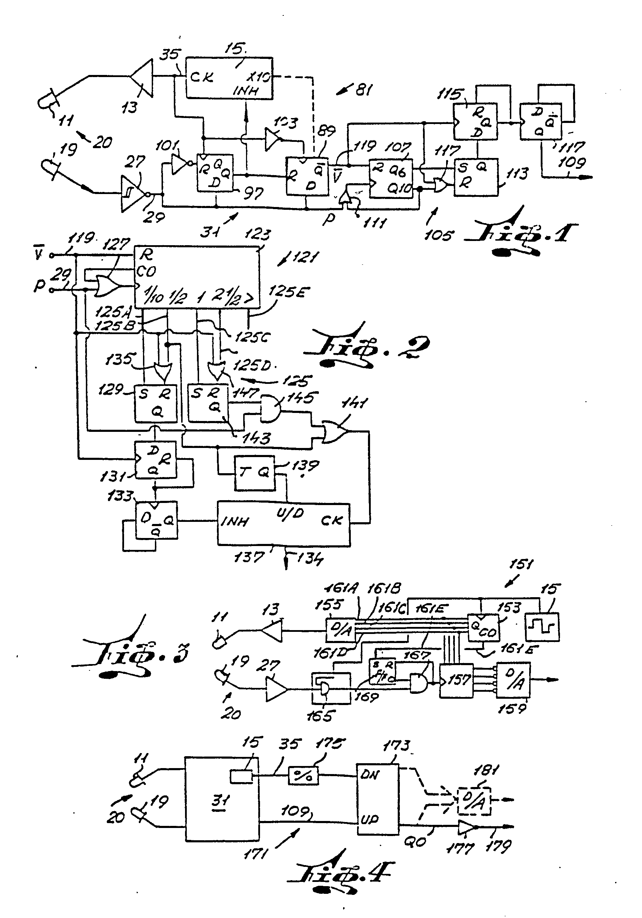

Figure 1 is a circuit schematic of an optoelectronic switch in which the present invention finds application.

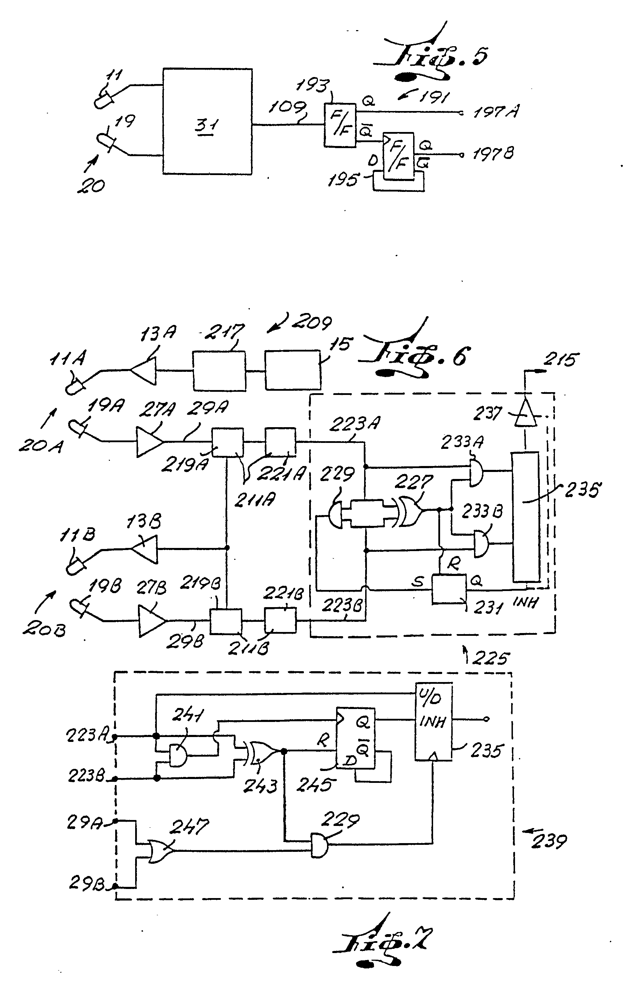

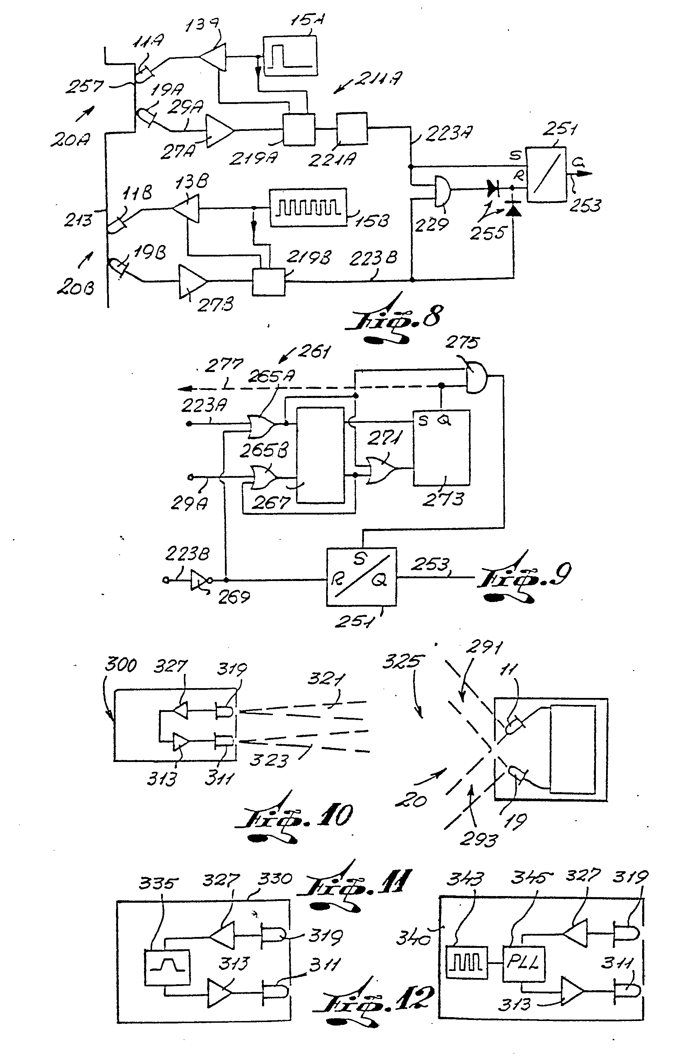

Figures 2, 3, 4 and 5 represent different embodiments of the first aspect of the present invention, wherein the optical assembly comprises a single emitter/receiver pair, and its responses to different activation parameters. In particular, in figure 2 the activation variable is time, in figure 3 it is distance (which may be suited to approach velocity) and in figure 4 it is the quantity of activations or strikes. In figure 5 the invention is referred to an output-variable for controlling a tri-intensity (i.e. double-filament) light-bulb.

Figures 6 to 9 are related to the second aspect of the present invention wherein the apparatus includes multiple optical emitter/receiver assemblies whereby the control parameter is "position". Each of the circuits of figures 6, 7, 8 and 9 illustrate different variations regarding the analysis of this parameter and the generated response.

Figures 10, 11 and 12 refer to yet another aspect of this invention regarding an arrangement having remote-control, figure 10 illustrating an essential schematic of the arrangement and figures 11 and 12 two more sophisticated embodiments of the remote-control circuit.

Figure 1 is a digital embodiment of a detector and a checking circuit associated with an optoelectronic switch. A radiation emitter in the form of a light-emitting diode (LED) 11 is lighted by a driver amplifier 13 under control of a generator 15. The emitter 11 issues red or infrared radiation which normally does not impinge on an optical receiver 19 of the emitter/receiver pair (assembly) 20. The receiver 19 is preferably a phototransistor responsive to the same wawe-length of the radiation generated by the emitter 11.

In the mode of operation, a person moves a hand near to the switch formed by the emitter/receiver pair 20, causing part of the emitted radiation to be reflected by the hand, thus forming a reflected wave incident on the phototransistor 19. In response to the reflective wave, the receiver 19 sends a response signal successively through an adapter-amplifier 27, a line 29 and an activation circuit 31. The function of the latter is to check that the detected signal is phase-coincident with the pulse-train placed by a generator 15 on a first output line 35 and to produce a response in the form of an activation signal if said coincidence checks positively during a predetermined quantity of successive cycles. In this way, for example, this circuit is capable of inhibiting all response when subjected to a long activation, whilst very intense ambient light causes it to stop generating power pulses at the emitter 13 and upon detecting a reflection it quickens the pace of said pulses, in similar fashion as employed in smoke-alarm circuits operating under the Tyndall effect.

The generator 15 comprises a master-clock providing output pulses with a duty-cycle of approximately .1% or less. These narrow pulses are transmitted from this clock 15 and pass through the current amplifier 13 before driving the emitter-diode 11.

The circuit of the receiver-diode 19 extends through the amplifier 27, which includes a Schmitt-Trigger inverter, into the respective data-inputs (D) of two flip-flops 97, 99 and at the same time, via a logic inverter-gate 101, into the reset-input (R) of the flip-flop 97. Both flip-flops 97, 99 are clocked with the same signal from the clock 15 which generates the pulses for the emitter 11, with the interposition of an inverter-gate 103 before the clock-input (CK) of the second flip-flop 99, such that both flip-flops 97, 99 are clocked at opposite edges of the pulse-train. The Q-output of the first fli-flop 97 is used both for resetting the flip-flop 99 and for stopping the clock 15 via its inhibit-input (INH).

This Q-output of the flip-flop 97 is set when light impinges on the receiver 19 and the output of the clock 15 is high before a driving pulse is sent to the emitter 11. Because of the light propagation delay inherent in turning on the emitter-diode 11, light will not be present in the receiver 19 when the clock 15 transmits a positive pulse. In this manner, the flip-flop 97 is triggered at that same instant in order determine if light is inciding on the receiver-diode 19. If there is light at that instant, the clock 15 is inhibited and the flip-flop 99 is automatically reset if previously set. When the light stops shining on the receiver 19, the output from the inverter 27 comes low and the output from the inverter 101 goes high, resetting the flip-flop 97 such that the clock is uninhibited and the flip-flop 89 is enabled again.

If no extraneous light is affecting the receiver 19, the flip-flop 97 is not set and the flip-flop 99 is triggered at the end of the pulse inverted by the inverter (NOT-gate) 103. Triggering of the flip-flop 99 sets its Q-output if at that moment light forthcoming from the emitter 11 is reflected back towards the receiver 19, in order to speed up the clock so that its repetiton rate increases approximately ten-fold. In this way the aim of producing pulses sporadically when the circuit is in a stand-by state is accomplished, thereby extending the lifetime of the circuit elements and reducing the energy consumption.

The respective inverted-outputs $\overline{Q}$ of the flip-flop 99 and the trigger 27 are used to check if an external reflecting member is present in the emitter/receiver system 20 or if continuous light is shining on the receiver 19, by means of a second stage 105 in the receiver circuit 31. This circuit 105 comprises a counter 107 for producing a safety window for activating an output 109 of the device. The counting pulses for this counter 107 are provided by the receiver-diode 19 and the trigger 27 via a logic OR gate 111. This gate 111 carries out a clamping function to stop the count when one of the more significant outputs Q10 of the counter 107 is set, so that this counter 107 may not flip-over.

Both the Q6 and Q10 outputs of the counter 107 are used to provide the necessary window, at approximately .1 sec (one-tenth of a second) and .8 sec respectively after the optical reflection condition has been detected. The first output Q6 directly activates an SR-type flip-flop 113 to provide a logic-high signal in the data-input (D) of a D-type flip-flop 115. The flip-flop 115 operates as a logic AND gate and could be replaced in an alternative embodiment by a gate of this type; however it is preferable to use a flip-flop 115 for this function because its input will only be set before a clock signal. The second output Q10 of the counter 107 proceeds via a logic OR gate 117 to the reset-input of the flip-flop 113. The gate 117 is also provided with the substantially continuous $\overline{Q}$ signal from the flip-flop 99, to reset the flip-flop 113 when the optical switch 20 is unblocked or when untimely light is detected at the receiver 19. The flip-flop 113 is also reset with a high output from the counter 107 once the .8 sec interval has timed-out, thereby resetting the Q-output of the flip-flop 113.

The Q-output of the flip-flop 115 feeds both its own reset-input (R) and the clock-input of a T-type (toggle) flip-flop 117, since its inverted-output $\overline{Q}$ is fed back to its data-input D. The Q-output from this flip-flop 117 is the binary output 109 of the activation circuit 31, the signal of which toggles with a valid reflection lasting not more than .8 sec. If it lasts longer, the counter 107 will clamp and the flip-flop 113 will reset the D-input of the flip-flop 115 upon the occurrence of a clock pulse forthcoming from the inverted-output $\overline{Q}$ of the flip-flop 99 when the hand is taken away from the region influencing the optical switch 20, in which case the output 109 will remain unchanged.

Figure 2 shows a schematic of the embodiment which, according to the present invention, combines a single emitter/receiver pair 20 with electronic circuit means 121 for analysing the dwell-time of an external member on the former to control an output-response at will. A plurality of time-windows are defined and sequentially activated one at the time, each window corresponding to a predefined output function. That is, this embodiment produces an output which is a function of the time during which the optical switch 20 is activated or blocked. These windows may be defined, for example, to respectively open and close between .1 sec and $^{1}/_{2}$ sec; $^{1}/_{2}$ sec and 1 sec; 1 sec and $2^{1}/_{2}$ secs; respectively, counted from the moment the switch 20 is blocked. A fourth window may be assigned between $2^{1}/_{2}$ and 5 secs or, in the case of a 4-bit output in which it would be the last window, remain open from $2^{1}/_{2}$ seconds onwards until the switch 20 is unblocked (the hand removed).

By way of example, figure 2 shows an embodiment wherein an output stage 121 replaces the stage 105 in figure 1. The output stage 121 is supplied by two lines 119, 29 respectively coming from the outputs of the latch 99 and the trigger 27 (figure 1), which respectively conduct a validation signal $\overline{V}$ (inverted,

i.e. active-low) and the pulse-train P sensed by the receiver 19.

The validation signal $\overline{V}$ is fed by the line 119 to the reset-input R of a counter 123. This counter 123 is internally configured as a chain of shift-registers associated to respective outputs 125 and is responsible for analysing validated pulses by sequentially enabling the respective time-windows. The counter 123 is held at nought (zero, cleared) by the line 119 as long as no validation signal is present and until the switch 20 is not blocked.

The pulse train P is conducted by the line 29 to a logic OR gate 127 which directly passes these pulses on to the clock-input of the counter 123. The remaining input of the gate 127 is connected to the carry-output (CO) to inhibit the gate 127 and thus prevent the counter 123 from responding to additional input pulses once its counting state has reached its magnitude. In this way, the enabled windows are not recycled to discourage unintended activations.

The first output 125A from the counter 123 corresponds to a window starting from .1 sec after blocking and sets a flip-flop 129, which in turn immediately sets a latch 131 high (this latch 131 could be substituted with a logic AND gate). The latch 131 is reset (R) by its own output Q such that, once the first window is open, it generates a very narrow pulse when the switch 20 is unblocked, since the signal $\overline{V}$ takes on a steady logic high level which triggers the latch 131. The output pulse of the latter in turn triggers a T-type flip-flop 133 which alternatively inhibits and enables an ouput circuit 137. In this manner, the switch acts as a simple binary device when the blocking-time is less than $1/2$ sec. The output circuit 137 may be embodied with an up/down counter having an inhibit-input (INH) connected to the flip-flop 133, an up/down-input (U/D) which sets the count direction and a clock-input (CK) responsive to each validated pulse.

The second output 125B of the counter 123 and the validation line 119 are both connected to a logic OR gate 135 to reset the latch 129 or keep it reset whenever the optical switch 20 is unblocked or a second window is opened, closing the first when $1/2$ sec has elapsed since the blocking commenced. In this manner, even though this time interval is outlasted and the switch 20 is unblocked, the clock-pulse reaching the flip-flop 131 will not cause an output-pulse nor will it alter the output-state of the flip-flop 133, and therefore neither will there be any response at the output 134. The output 125B causes the output 134 to rise or fall by means of a T-type flip-flop 139 connected to an up/down-select input of the output counter 137. In this way, the output 125B alters this up/down-input of the counter 137 with each new blocking lasting at least $1/2$ sec. The output 125B carrying the $1/2$-sec signal also supplies a logic OR gate 141 connected to the clock-input which indexes the counter 137.

The third output 125C of the counter 123 sets a flip-flop 143 connected to a logic AND gate 145. The gate 145 is also supplied with the clock pulses present on line 29, to pass them to the pulse-input of the output counter 137 via the gate 141 when the flip-flop 143 is set. The output 134 is thus changed according to the time lapsed since the optical pair 20 was blocked.

The output 125D of the counter 123 is set $2^1/2$ secs after the switch was first blocked to reset the flip-flop 143 through a logic OR gate 147, as is also the case when the validation signal on line 119 is not active. The output 125D and the output of the gate 145 are used (in a manner which is not shown but which one skilfull in the art could figure out for himself) to keep the circuit inhibited once the last window has timed-out. More outputs 125E from the counter 123 could be further added to assign more windows and thus provide more output functions.

The output 134 may be a single line providing a multi-valued signal which enables an output parameter to be controlled, such as intensity or power of a load-device connected thereto, or alternatively, a Johnson-type counter could be used as the circuit 137 to selectively control a plurality of devices by acting on a single optical pair 20, wherein the selection function is likewise based on the dwell-time. In this as in the other embodiments in general, the input parameter analysis may be combined with different output responses. One of such combinations particularly consisting in each block/unblock cycle on the switch 20 selecting just one output line to relay an effect to a load connected thereto, determined according to the window in which the time-interval between blocking and unblocking lies. This effect consists in switching this output, i.e. activation (starting, turning on, etc.) if at that moment the line was deactivated, or else deactivating (power-down, stop, etc.,) if it was activated. Optionally, it may be provided that one of the windows produce a certain effect on all the out puts. For example, the first window may be assigned as a master-reset of all the outputs.

Figure 3 shows an analyser circuit 151 responsive to the distance between the hand and the switch 20. The switch assembly 20 comprises an emitter 11 which is modulated by sixteen consecutive pulses of increasing intensity with the aid of a counter 153 connected to a 4-bit digital-to-analogue converter (D/A) 155. This sequence progresses in stepped fashion whenever there is no reflection and until a reflection pulse is received.

When a reflected beam is detected by virtue of the proximity of a hand, the same is checked (verified) in a manner not explained herein since it is not essential to the present invention, but which is disclosed by way of reference, in the Argentine patent n° 237,461. Thereafter, the analyser means consisting of a latch 157 is enabled to be triggered whenever a verified reflection is recognized and loaded with the count at which the counter 155 stands at that moment. This count information represents the "remoteness" of the hand, since whenever the light emission strength is increased the distance at which a recognizable reflection is possible does also proportionally, as long as a like reflector object is used. The latch 157 feeds an output digital-to-analogue converter (D/A) 159 producing a continuous numerical signal which varies as the hand approaches the pair 20. The four bits between the latch 157 and the converter 159 are inverted, in order to adapt the operation to human logic, i.e. the nearer a hand the greater the output. Consequently, the D/A converter 159 converts the complement of the value held in the register 157.

If the hand is moved sharply aside, i.e. perpendicular to the beam, the latch 157 retains the last value stored. On the other hand, the output may be simply inhibited or unhibited by simply "slicing the beam" during a time-interval shorter than the threshold, for example $1/2$ sec.

A method for clarifying the circuit and achieving the maximum intelligence therefrom consists in the pulse emitter 11 only transmitting stronger pulses than the sixteen provided by the counter 153, until a function separation threshold (.8 sec) is passed. After this interval, the stepped output is enabled, the sixteen pulses of which occupied the same time-interval as the sporadic stronger stand-by pulse.

Describing figure 3 in more detail, the electronic circuit 151 associated with the optical pair 20 comprises the oscillator 15 which supplies the 4-bit counter 153. In addition to its four outputs 161, this counter 153 has a fifth output 161E which sets when the maximum count has been reached to reset the other four bits 161A, 161B, 161C, 161D to nought. These four outputs 161A-D directly feed into the D/A converter 155, which in turn provides an output for the current signal amplifier 13 for driving the emitter 11.

The signal eventually reflected enters the detector 19 and passes by the amplifier 27 having a Schmitt-trigger to a logic AND gate 165. The gate 165 is also supplied with a pulse-train by the oscillator 15, in phase with the signal received by the counter 153. In the normal state, there will be no active response in the gate 165 during the time the emitted pulses do not get to be reflected because of their low power, in spite of the counter 153 receiving clock-pulses. But when the threshold determined by the Schmidt function of the device 27 is reached, corresponding to the distance to the hand, the output from the Schmidt-trigger 27 switches to high in synchronism with the corresponding pulse from the oscillator 15, thus producing an activation pulse at the output of the gate 165. This activation pulse is directly sent to a second AND-gate 167.

In turn, a flip-flop 169 receives a setting pulse directly from the carry-output 161E of the counter 153, setting it with each counter cycle when the four bits are low. Since its Q-output supplies the other input of the gate 167, the latter is enabled to let through the first positive output pulse received from the gate 165. The corresponding output is obtained as soon as the latter is thus validated, to automatically reset the flip-flop 169 and thus prevent detecting the other output pulses from the gate 165 corresponding to pulses of higher intensity which could be received by the reflection. This validated pulse at the output of the gate 167 is sent to the 4-bit latch 157 and is used to enable the latter to produce at its output the same bit combination present at that moment at the former's input, which combination is directly supplied by the bus 161 which communicates the counter 153 with the first D/A converter 155.

In this way, the latch 157 retains the digital analysis corresponding to the value in the counter 153 at the moment that the first effective pulse is checked by the circuit 151. This value is directly proportional to the intensity of the light transmitted by the emitter 11 and, furthermore, is directly proportional to the distance from the hand to the respective emitter/receiver pair 20, since the greater the distance the greater transmission power necessary to produce the first validated pulse.

Since the inputs to the converter 159 are inverted, the output takes its maximum value when the hand is nearer and, conversely, a minimum value of nought when the hand is farthest away from the emitter/receiver pair 20.

The distance analysis may be carried out differently, as mentioned hereinafter, without reference to the drawings however since they are simply variations of the embodiment of figure 3.

A different way of determining the distance and generating an output may be done by analysing the frequency parameter. In this case, the frequency of an oscillator 15 is varied with a reset signal. The nearer the hand, the faster the reflection of the emitted beam due to the increasing energy content of each pulse. Since the reset cycle is cut short before the emitter pulse has finished, the oscillator cycle is shortened. It is also possible to integrate either the emitter or the receiver pulses to smoothen the response and broaden the scope of action.

Still another way is by analysing the width of the reflected pulse, since the farther away the reflection point is the shorter the detected pulse will be, using a milder wave-form to drive the emitter 13. The other way of determining the distance is by analysing the reflection intensity. To this end, a single-level pulse is transmitted and the response received at the receiver 19 is measured with an analogue-to-digital converter A/D connected at the output of the input amplifier 27 wherefrom the output value is directly determined.

A circuit for analysing the approach velocity of the hand, or conversely the speed at which it moves away from the switch 20, may be derived from that of figure 3. For instance, the circuit 151 could be modified (not illustrated) to register two succesive distance values by duplicating means 151 and latching them in timeseparated sequence, and further providing circuit means to enable the D/A converter 159 to transmit the difference between the thus registered distance values.

According to another embodiment of the invention, the output response to the quantity of activations or "strikes". In this manner it is possible, for example, to set the time of automatic lighting in buildings, by touching (blocking) the switch 20 various times, adding one minute with each touch up to fifteen minutes and resetting down to nought with the sixteenth touch.

An apparatus for this embodiment comprises a driver/detector circuit 31 associated with the optical pair 20 and an analyser/output circuit 171. The former corresponds to the entire schematic illustrated in figure 1 whilst the circuit 171 is schematically shown in figure 4. The output 109 of the detector circuit 31 supplies validated pulses to the up-input of a non-recyclable up/down counter which functions as a timer device. Such validated pulses respond to respective blocking and unblocking sequences as may be recalled from the description of figure 1. The down-input (DN) of the timer-counter 163 is connected by means of a divider-counter 175 to the output 35 of the master generator 15.

When a person repeatedly "strikes" the switch 20, the validated pulses increment the counter 173 until a certain non-zero state, such that its output QO is at a low logic level. The output level QO is inverted by a logic gate 177, such that the apparatus output 179 is activated. The divider 175 is designed to let one pulse per minute pass to the counter 173, such that the latter's state slowly counts-down to nought at which instant the output QO changes state. In this situation, the output 179 is back to nought, which, for the case of a building timer, means that the timer has reached its nil state and the hall light is therefore turned out, since the same number of minutes has elapsed as the number of times the optical switch was activated. Thereafter, the apparatus stands-by until the switch 20 is struck again.

Figure 4 shows in dashed lines how the output may be modified by means of a circuit 181 to implement a different function. For example, a D/A converter 181 may be connected to achieve an output linearly decreasing with time, most useful in children's bedrooms, for controlling a light which is slowly turned off when they are laid down to sleep.

Other embodiments based on the quantity of activations may have a single output by means of a counter 173 and a D/A converter 181, wherein the output level jumps by small steps with each strike, said level being retained until a new activation. Each strike can modify the state of the counter 173 in one unit in a certain direction up to a maximum (increasing) or minimum (decreasing) limit, whereafter it may jump to the opposite limit and either restart the count in the same direction or else count back other way.

A very elegant embodiment results from combining both the methods just referred to for a time-control assembled as a control by activations or strikes. Short repetitive strikes increase the counter 173 whilst a continuous blocking of the pair 20 imposes a downward count on the counter 173 according to the duration thereof. The corresponding circuit design may be evident to those knowledgeable in the art, specially in view of the disclosure of figures 3 and 4.

According to another aspect of the invention, figure 5 shows an embodiment having a circuit providing three different fixed intensities in addition to the off condition, to thus replace switches for tri-intensity light-bulbs. The receiver stage 191 includes a first T-type flip-flop (F/F) 193 cascaded with a second, similar, flip-flop 195. The clock-input of the latter is connected to the inverted-output $\overline{Q}$ of the preceding flip-flop 193. In turn, the $\overline{Q}$-output from the flip-flop 195 is connected to its own D ("data") input. In this way, the two outputs Q from both flip-flops 193, 195 divide the two output-bits 197A, 197B which achieve the three illumination points equivalent to a tri-intensity lamp, replacing in this way a double mechanical switch. These two-output bits 197 are weighted to provide three different intensity values and a no-intensity value, the latter when both bits 197 are low; the transitions of the values of both bits 197 progressing only in response to an activation/no-activation sequence on the optical pair 20, always within a preassigned window.

A block-diagram schematic of an electronic circuit for an apparatus 207 controlling a multiple valued variable by finger position is shown in figure 6. In particular, the apparatus of the figure 6 comprises two optical pairs 20A, 20B. The circuit 209 associated to the emitters 11 is common to both, not so the circuits 211A, 211B associated to the respective receiver-diodes 19. Both emitter/receiver pair 20 will be generally arranged for greater ease of operation, one 20A in the upper part and the other 20B in the lower part of a common panel 213, such that by operating the upper pair 20A the intensity of the signal present at an output 215 of the apparatus 207 increases whilst operating on the lower pair 20B brings about exactly the opposite, i.e. its intensity is decreased. This device may find application as a light intensity regulator provided with a direct control, for example, wherein the light is made to shine brighter by blocking the upper assembly 20A and to slowly go out when the lower assembly 20B is blocked.

On the other hand, the circuit 207 of figure 6 further includes means for inhibiting the output if both optical pairs 20A, 20B happen to be blocked at the same time.

Within this basic scheme, the activation function may be carried out in two different manners, in one of them continuously varying the output whilst the blocking finger is kept over one of the pairs 20, or else, according to another option, letting the output 215 jump by steps with each activation. In other words, to produce a quantitative jump in the output 215 it will be necessary to hand-strike one of the pairs 20 a number of times to successivelly block and unblock it. This latter mode of operation is the one implemented in the circuit of figure 6 which is described in detail hereinafter.

The control circuit 209 for the emitters 11 comprises a master-clock in the form of an oscillator generator 15 and a pulse-shaper circuit 217 connected to the output thereof and which simultaneously sends drive control pulses to the respective current amplifiers 13A, 13B, whilst at the same time providing a clock signal for the respective discriminator circuits 219A, 219B which form part of both circuits 211 associated with the receiver section. Both discriminators 219 receive the signal through respective signal amplifiers 27A, 27B having Schmidt properties. In each case, a respective counter 221A, 221B is connected to the output of each discriminator 219 to provide the desired safety window, such that both divider counters 221 provide respective validating outputs (V) 223A, 223B which are combined in a control circuit 225.

The control circuit 225 includes an exclusive-OR ("EXOR") logic gate 227 and a logic AND gate 229. An inhibiter device 231 comprised by a flip-flop has its set-input connected to the output of the AND-gate 229 and its reset-input connected to the logic EXOR-gate 227. Paralelly there are two logic AND-gates 233A, 233B having two inputs each, one of which is connected to the corresponding validating line 123 whilst the other is connected, together with its pair, to the output of the gate 227.

In this manner, if both optical pairs 20A, 20B are blocked at the same time, both lines 223 will have high validating signals and there will be no switching at the output of the EXOR-gate 227. On the other hand, the device 231 will be set and its output Q will inhibit an output counter 235, and preferably also an output amplifier 137 supplying the output line 115.

Conversely, if only one of the optical pairs 20A, 20B is blocked, the gate 229 remains closed and the flip-flop 231 is not set. On the other hand, there will be a active change at the output of the gate 227 which will reset the flip-flop 231 and enable both gates 233, one of which will let the corresponding validating signal through to increment or decrement the counter 235 according to which pair 20 was activated. There will be only one counting pulse whilst the hand is kept over the assembly 20, and the counter will only increment or decrement in a single quantum or unit the signal intensity present at the output 215. It may be pointed out that whilst two complete optical pairs 20A, 20B are illustrated, it is possible to embody them such that they share one of the emitter or detector elements 11, 19, as was mentioned at the beginning.

Figure 7 shows an alternative to the type of design of figure 6, wherein the variation of the output is continuous on the basis of the time that the finger is kept over one of the pairs 20A, 20B, which time is the detection parameter of the apparatus 207. This circuit is similar to the one just described in figure 6, the difference being in that apart from sending their respective validation signals over the lines 223 to keep the counter 235 enabled, the respective outputs 29A, 29B from the receivers 19A, 19B are used to provide the counting pulses. In particular, the activation stage 225 of the circuit 207 of figure 6 is substituted with an activation stage 239 schematically shown in the figure 7.

The validation signals 223 directly enter the respective inputs of a logic AND gate 241 and an EXOR-gate 243. In turn, the gate 241 directly feeds the clock-input of a flip-flop 245 configured in the "T" (toggle) mode so that it switches its output in response to each input pulse. This output Q of the flip-flop 245 directly feeds the inhibit-input of the counter 235.

For its own part, in addition to feeding an input of the AND-gate 229, the EXOR-gate 243 feeds the reset-input of said flip-flop 245 to reset it whenever just one of the pairs 20 on the control panel 213 (figure 6) is blocked, enabling it to receive the pulses from the other logic OR-gate 247. The latter combines the pulses directly forthcoming from the outputs 29A, 29B to form the counting pulse for the counter 235. There will only be a response when pulses are received in just one of the inputs of the gate 247, since the apparatus will be blocked by the gate 229 if simultaneous pulses are supplied at the same time to both inputs of the gate 247.

The gate 229 supplies the clock-input of the output circuit of the clock 235, causing it to progressively increment or decrement the output thereof whilst keeping either the upper pair 20A or the lower pair 20B respectively blocked. A last control signal is directly sent via the line 223A to the up/down-selector input (U/D) of the counter 235.

Turning now to figure 8, the case of an apparatus wherein the on and off functions are not complementary as in the previous cases, i.e. one type of action is needed to turn the load on and another to turn it off, is shown. In particular, it is a circuit wherein the controlled element will be switched off by simply moving the hand near to or resting it against the control panel 213, whilst a more stringent condition must be met to reactivate operation. This mode of operation is specially recommended for risky situations or as a safety measure, for instance as a precaution against accidents caused by children. For example, the apparatus of the figure 8 can be used to handle pumps, motors, swimming-pool filters, hydromassauge machines and so forth where there is always a high element of risk because of the proximity of water.

This is embodied by a panel 213 provided with two pairs 20 one of which, for instance the upper pair 20A, is assigned to the on condition and the other 20B to the off. The first difference between one another is a safety window provided for the first action which is much narrower and more lengthy in time, whilst the response to the second action, i.e. turning off, is instantaneous under any reflected pulse detected by the receiver-diode 20B. Said window may be comprised between 1 and 1.2 sec, for instance, such that a most exact activation will be required, something difficult to expect from a child.

Another difference relative to the previous circuits having two optical pairs 20A, 20B is that in figure 8, the two emitter-diodes 11A, 11B are driven from separate pulse generators 15A, 15B. Specifically, the emitter 11B corresponding to the off-switch 20B provides a pulse-train having a repetition rate substantially faster than the pulse-train outputted by the pulse generator 15A associated with the start-switch 20A, in order to embody the purpose just stated.

The receiver-diodes 19A, 19B are connected to respective independent circuits 211A, 211B which are similar to those described in figure 6 up to the counter 221. The output element is a flip-flop 251 providing a binary output 253 for the device. The set-input S of the flip-flop 251 is directly connected to a line 223A corresponding to the validation signal generated by a start receiver circuit 211A, whilst the reset-input R of said flip-flop 251 is connected to the line 123B corresponding to the validation signal outputted by the stop receiver circuit 211B.

Aside from the different repetition rate of the generators 15, there is another safety element provided by a logic AND gate 229 which takes both validation signals on the lines 223A, 223B to generate a reset signal for the output flip-flop 251 if such validation signals are generated simultaneously (which, as may be appreciated, has been foreseen could happen if both optical switches 20A, 20B are blocked for an interval of 1.1 sec). In this manner and in contrast to the previous embodiments where all action was inhibited by the simultaneous presence of both validation signals, in the circuit of the figure 8 a reset signal is generated in such a situation to make sure that the load element controlled by the relay connected to the terminal 253 is switched off. The diodes 255 simply conform a logic OR gate to allow both reset signals to be combined.

Yet a another safety feature embodied in the apparatus of figure 8 is brought about by a recess 257 provided in the front or panel 213 of the switch and wherein the devices 11A, 19A pertinent to the start switch are inset in a recess. Preferably, the recess is deep enough so that the zone where the respective propagated and reflected beams defined by the positions of the photo-devices 11A, 19A intersect is substantially inside the recess. In this manner it is prearranged that accidental touches which could eventually occur primarily affect the off switch 20B, since it will be necessary to penetrate the vertical plane of the panel 213 to block (reflect) the start switch 20B, which requires to a more wilfull act.

Figure 9 illustrates a variation of this type of circuit. In addition to the two validation signals taken from the lines 223, the output stage 261 also has an input connected by a line 29A to the output of a trigger 27A for receiving pulses clocked with the response from the diode-detector 19A corresponding to the start switch 20A. No pulses forthcoming from the remaining diode receiver 19B are supplied for this stage 261.

Both the lines 223A, 29A capable of conducting the validation signal and the pulse-train respectively coming from the input circuit 211A are inputted to respective logic OR gates 265A, 265B. The output from both these gates 265 are respectively connected to the reset (R) and clock-inputs of a counter 267, the function of which is to determine counts of 1 sec and 1.2 sec which define the window necessary to activate the start-control output.

The off-validation signal is carried by the line 223B to a logic inverter-gate 269 which supplies the other input of the gate 265A and the reset-input of the output flip-flop 251. On the other hand, the other input of the gate 265B is connected to the second output, that is, the window maximum (in this case 1.2 sec) of the counter 267, which is also connected to a logic OR gate 271. The other input of the latter 271 is provided by the output of the gate 265A. The output of this gate 271 directly resets an RS-type flip-flop or latch 273 the output of which is normally logic-high until a pulse is received from the gate 271, to keep the window open from the moment it is activated by the early output (corresponding to 1 sec) of the counter 267.

The Q-output from the flip-flop 273 feeds one of the two inputs of a logic AND gate 275, another input of which also comes from the gate 265A and is set high when the top "button" 20A of the optical switch is unblocked. If at this moment of unblocking the Q-output from the flip-flop 273 is set, indicating that said unblocking occurred within the window assigned to the counter 267, there will be for just an instant a logic-high level in both inputs of the gate 275; since the moment in which the switch 20 is unblocked and the gate 275 consequently enabled the counter 267 is simultaneously reset, all due to the output of the gate 265A. The flip-flop 273 is also reset. In spite of that the pulse salient from the gate 265 is very short or narrow, it is however sufficient to set the flip-flop 251.

The output flip-flop 251 is reset and the optical switch 20B is blocked, thereby generating a logic-low signal on line 223B which is inverted by the NOT-gate 269 feeding the reset-input of the former. In other words, the output line 253 may be reset with a very sporadic blockage of the switch 20B. The reset signal coming from the gate 269 is also directed by the gate 265A to reset the flip-flop 267 and prevent the window from being enabled should the top switch 20A of the panel 213 also be blocked.

The panel 113 may optionally include a display lamp (not illustrated) which lights up during the .2-sec time-interval when the window is enabled by the counter 267. This display lamp may be controlled with a line 277 (shown dashed) connected to the Q-output of the latch 273. This may be used for the user to tell when he should remove his hand since, from what may be understood from the description of the operation of the circuit figure 8, blocking the switch 20A for a time longer than the duration of the window will have no effect on the output.

To be more practical, the emitter element 11A corresponding to the on-switch 20A may comprise a small green-coloured emitter-diode, whilst the stop-switch 20B may be red-coloured and larger or more powerful.

Despite all the advantages of the optoelectronic switches described herein, it is still necessary to be near them to be able to switch them. This, apart from being bothersome for most people, could be difficult or perhaps even impossible for elder people or those with physical or health problems. Of course, this dis advantage is inherited from the conventional mechanical switches.

It could be possible to attain remote-control safely and precisely with a high degree of reliability taking advantage of the electronic nature of the switches covered by this patent. In theory, this could be achieved with a highly efficient and extremely directional passive optical reflector, if the emitter beam and the receiver sensitivity were sufficiently great. However the latter does not occur in practice and is inconvenient anyway, because a very strong emitter and a very sensitive receiver would promote accidental activations from people working by the control panel, albeit at a considerable distance, creating sporadic reflections. Consequently, the present invention further includes, by way of accessory, an active reflector of the transponder type, capable of interacting with a special optoelectronic switch 20, to overcome the maximum distance for switching by passive reflection (maintaining this distance to its recommended value from 5 to 15 cm). Said special switch 20, for mounting on the wall, is provided with optical elements 11, 19 featuring wide propagation and detection angles 291 and 293 respectively.

Figure 10 shows a remote-control unit 300 containing a receiver 319 and an emitter 311 connected by a signal amplifier 327 and a driver 313. The pulses outputted by the emitter 11 of the unit 20 to be controlled are detected by a receiver 319 in the remote-control unit 300. Said receiver 319 has a very acute angle of incidence or detection 321, so that it is highly directive. The pulses are received, shaped and amplified by the devices 327, 313, and delivered to the control emitter 311 which sends them off at a much higher power in the opposite direction to which they were received. The zone 325 indicates the maximum distance where a normal reflection is produced.

In this way, the receiver 19 of the switch 20 receives pulses in the correct phase (although with a slight delay) and synchronized with the emitted pulses and, since it cannot distinguish those pulses coming from the other emitter and not directly from itself, it proceeds to activate its checking circuits as if it were a passive reflection. For example, if the switch were responsive to a reflection wherein the pulse emission frequency rate increased, it would still be responsive and the active reflector would re-send the pulses at the same rate, thus achieving a simulation of a true reflection.

Figures 11 and 12 respectively illustrate two embodiments 330, 340, conveying improvements in relation to the remote-control unit 300 of figure 10. The unit 330 incorporates a selective filter 335 tuned near the operating frequency. When the remote-control 330 is enabled to start receiving light pulses to be retransmitted, the filter 330 cancels sporadic pulses and the 100/120 Hz signal range present if there is artificial illumination (specially fluorescent). In this way the switch 20 is not confounded by pulses which in normal use would not affect it but when amplified by the remote-control 300 could trigger it and make remote-control difficult.

To the same end, figure 12 includes an oscillator 343 and a phase-locked-loop (PLL) circuit 345 operating at a frequency around the oscillator 15 of the switch 20. With this circuit 343, 345 the remote-control 340 will only transmit continuous pulses.

**Claims**

1. A multifunctional optoelectronic apparatus for producing a controlled response at an output (134; 174; 197) thereof and including an optical switch assembly (20) comprised by emitter means (11) for transmitting a radiation beam along a normal propagation axis and corresponding receiver means (19) responsive to radiation reflected from said axis by external blocking means into a line of incidence on said receiver means to provide an activation signal, characterised by further comprising analyser means (123; 157, 167, 169; 171; 191) connected to said receiver means for detecting a predetermined parameter of said activation signal, and ouput means (129-147; 159; 171) connected to said analyser means for outputting an apparatus response according to a predetermined function of said parameter.

2. An apparatus according to claim 1, characterised in that said optical switch assembly solely consists of just a single light-emitter device and a corresponding single light-receiver device.

3. An apparatus according to claim 1, characterised in that said predetermined parameter is indicative of the distance between said blocking means and switch assembly or the translation speed of said blocking means relative to said switch assembly; and further characterised in that said analyser means comprise means (153) for generating a periodical time-varying signal to modulate power pulses transmitted by said emitter means, latch means (157) for registering instantaneous data representative of said time-varying signal, and means (165-169) for detecting a first response from said receiver means to close said latch means, whereby said latch means thereafter retains the data corresponding to said first response.

4. An apparatus according to claim 3, characterised in that said detecting means include a flip-flop (169) and logic AND gate means (165, 167), said gate means connected to said receiver means and to said generating means for resetting said flip-flop in response to an activation pulse outputted by said receiver means in time-coincidence with one of said power pulses and for closing said latch means in response to said time-coincidence occuring when said flip-flop is set, said flip-flop further connected to said generating means to be set before the beginning of each time-varying signal period.

5. An apparatus according to claim 1, characterised in that said predetermined parameter is indicative of the dwell-time of said blocking means; and further characterised in that said analyser means comprises counter means (123; 173; 193, 193) connected to said receiver means to establish the number of consecutive reflection-response pulses received, indicative of said dwell-time.

6. An apparatus according to claim 1, characterised in that said predetermined parameter is indicative of the number of repetitive strikes of said blocking means with respect to said optical switch assembly; and further characterised in that said analyser means comprises verification circuit means (105) connected to said receiver means for generating said activation signal once a predetermined minimum number of consecutive reflection-response pulses are received, and counter means (123; 173; 193, 193) connected to said verification circuit means to be indexed by each block/unblock cycle of said external blocking means on said optical switch assembly.

7. An apparatus according to claim 5 or 6, characterised in that said output means includes a latching circuit (129-147) connected to said analyser means for defining a range of enable-windows and determining an apparatus response by comparing the predetermined parameter against said range.

8. An apparatus according to claim 5 or 6, characterised in that said counter means comprises an up/down counter connected to said receiver means and to a pulse-generator means so that the counter is incremented by each receiver-pulse and decremented by each generator-pulse, said generator means issuing pulses at a substantially slower rate than said emitter means, whereby said response is an output signal having a controllable active time-interval dependant on said function.

9. An apparatus according to claim 5 or 6, characterised in that said counter means comprises two flip-flops cascade-connected in a four-magnitude counter configuration providing two binary output lines connected to control a double-filament lamp.

10. An apparatus according to claim 1, characterised in that said output means comprises converter means (137, 195, 181) connected to said analyser means for producing an intensity-controlled output signal dependant on said predetermined parameter.

11. An apparatus according to claim 1, characterised in that said analyser means comprises means (123; 157, 169) for comparing said activation signal against a range of intervals and said output means comprises selector means (137) for enabling one of a plurality of distributed outputs according to the corresponding interval.

12. An apparatus according to claim 11, characterised in that said output means comprises means (177, 179) for initiating a collective response on one of said distributed outputs.

13. A multifunctional optoelectronic apparatus for producing a controlled response at an output thereof and including a multiple optical switch assembly (20A, 20B) including at least one emitter element for transmitting a radiation beam along a normal propagation axis and at least one corresponding receiver element (19) responsive to radiation reflected from said normal propagation axis by external blocking means into a line of incidence on said receiver means to provide an activation signal, said emitter and receiver elements comprising at least three elements forming at least two optical switches, characterised by further comprising analyser means (225; 239; 229, 255; 261) for detecting the position of said external blocking means relative to said assemblies, said analyser means including logic gate and flip-flop means (227-233, 241-245, 265-275) for detecting which of said two switches was activated, and ouput means (235; 251) connected to said analyser means for outputting a predetermined response according to said position.

14. An apparatus according to claim 13, characterised in that said analyser means include inhibit logic circuit means (229, 231, 243, 245) connected to detecting simultaneous responses from both optical receivers and thereafter either inhibit response of said output means or cause a predetermined one of said switches to preempt the other.

15. An apparatus according to claim 13, characterised in that said analyser means include means (15A, 15B, 211A, 219B) for immediately transmitting a response from a predetermined one of said switches whilst a response from the other switch is delayed until the predetermined parameter thereof meets a stringent condition.

16. An apparatus according to claim 13, characterised in that said multiple switch assembly includes two emitters elements spaced from each other on a panel supporting said switch assembly.

17. An apparatus according to claim 16, characterised in that said two emitter elements are of different colours and sizes to readily distinguish between them.

18. An apparatus according to claim 16, characterised in that said two emitter elements are connected to means for energising each emitter element with a different frequency or modulated signal.

19. An apparatus according to claim 16, characterised in that said two emitter elements are connected to be controlled by said output means to light up only one of the emitter elements according to the current state of the apparatus.

20. An apparatus according to claim 16 and also comprising two receiver elements, characterised in that one of the receiver elements is located together with its corresponding emitter element within a recess in the front panel.

21. A remote-control optoelectronic arrangement including an optoelectronic switch apparatus comprised by emitter means for transmitting a modulated radiation beam along a normal propagation axis and corresponding receiver means responsive to such modulated radiation reflected from said normal line of propagation by external blocking means into said receiver means to provide an activation signal; the apparatus characterised in that said emitter and receiver means both have relatively large angles of influence, and said arrangement further characterised by including a portable telecontrol unit for electromagnetically coupling with said switch apparatus, said telecontrol unit comprising highly-directive receiver and emitter means and an electronic transponder circuit connected between said highly-directive receiver and emitter means for retransmitting electromagnetic radiation received from the apparatus emitter means in the form of a narrow beam back to the apparatus receiver means.

22. A method for controlling a response at an output of an optoelectronic switch assembly comprised by emitter means for transmitting a radiation beam along a normal propagation axis and corresponding receiver means for generating an activation signal in response to reflected radiation produced by externally blocking said normal line of propagation at at least one point thereof, the method characterised by detecting and analysing a predetermined parameter of said activation signal, and generating a response according to a predetermined function of said parameter.

23. A method according to claim 22, characterised in that said predetermined parameter is indicative of at least one of the following activation parameters: the position of said point relative to said optoelectronic switch assembly, the distance from said point to said optoelectronic switch assembly, the translation speed of said towards or away from said optoelectronic switch assembly, the number of repetitive blocking strikes against said optoelectronic switch assembly or the dwell-time during which said blocking persists at said point, or a combination thereof.

24. A method according to claim 22 or 23, characterised in that said response is an output signal and said function is a linear variation of the intensity or timing thereof.

25. A method according to claim 22 or 23, characterised in that said function is distribution, and said activation signal is compared against a range of intervals for enabling one of a plurality of outputs according to the corresponding interval.

EP 0 324 606 A1

Fig.1

Fig.2

Fig.3

Fig.4

Fig. 5

Fig. 6

Fig. 7

Fig. 8

Fig. 9

Fig. 10

Fig. 11

Fig. 12

**EUROPEAN SEARCH REPORT**

. Application number

| | DOCUMENTS CONSIDERED TO BE RELEVANT | | EP 89300237.8 |
|---|---|---|---|

| Category | Citation of document with indication, where appropriate, of relevant passages | Relevant to claim | CLASSIFICATION OF THE APPLICATION (Int. Cl.4) |
|---|---|---|---|
| Y,P | DD - A1 - 261 454 (AKADEMIE D. WISS. D. DDR) | 1-3 | G 01 D 5/26 |
| A | * Abstract * | 4-25 | G 08 B 13/18 |
| | -- | | G 08 G 1/04 |
| Y,D | US - A - 3 086 146 (EDLER) | 1-3 | |
| | * Fig. 2,3 * | | |
| | ---- | | |
| | | | **TECHNICAL FIELDS SEARCHED (Int. Cl.4)** |
| | | | G 01 D 5/00 |
| | | | G 08 B 13/00 |
| | | | G 08 G 1/00 |

The present search report has been drawn up for all claims

| Place of search | Date of completion of the search | Examiner |
|---|---|---|
| VIENNA | 31-03-1989 | KUNZE |